Europäisches Patentamt

European Patent Office

Office européen des brevets

(11) Publication number: 0 241 905
A2

## EUROPEAN PATENT APPLICATION

(21) Application number: 87105498.7

(22) Date of filing: 14.04.87

(51) Int. Cl.4: G06F 13/40

(30) Priority: 14.04.86 US 851180

(43) Date of publication of application:
21.10.87 Bulletin 87/43

(84) Designated Contracting States:
AT BE CH DE ES FR GB GR IT LI NL SE

(71) Applicant: Siemens Aktiengesellschaft Berlin
und München
Wittelsbacherplatz 2
D-8000 München 2(DE)

(72) Inventor: Bier, Gerhard
Blumenstrasse 1
D-6742 Herxheim(DE)
Inventor: Nilsson, Sven, Dr.rer.nat.
Bolzweg 6
D-8024 Deisenhofen(DE)

(54) Circuit board for on-line insertion in computer system.

(57) A circuit board is provided for on-line insertion
into a computer system which has a plurality of
clock lines including a clock line for the board, a bus
and a system initialization line carrying a system
initialization signal. The circuit board interrupts traffic
on the bus during insertion of the board and decouples the clock line for the board from the other
clock lines. The circuit board also provides fully
distributed synchronization of the system initializa-
tion signal.

FIG 1

EP 0 241 905 A2

## CIRCUIT BOARD FOR ON-LINE INSERTION IN COMPUTER SYSTEM

Background of the Invention

This invention relates generally to a circuit board for a computer system and more specifically to a circuit board for on-line insertion in a computer system without crashing the sytem by stopping traffic on the bus during insertion of the board and decoupling various lines.

In a computer system, it is common to use a circuit board for deriving specific functions and for operation of the computer system. The computer system is typically equipped with a backplane which connects a plurality of terminals. The circuit board also typically has a plurality of terminals which intermesh with the terminals of the backplane when the board is inserted into the backplane. It is often necessary to completely disable the computer system or to disable that portion of the system into which a board is inserted or removed so that the board can be inserted or removed without crashing the system. When the computer system or the bus is not disabled, insertion or removal of te circuit board can cause errors in the system which can be quite troublesome. Accordingly, it will be appreciated that it would be highly desirable to provide a circuit board for insertion into an operating computer system without the necessity for disabling the sytem or interrupting the total bus function.

A demand for greater reliability in computer systems has helped evolve modern advanced computer systems which are increasingly equipped with redundant circuitry to dramatically increase the meantime between failures. This reduces the down time of the computer and makes the computer system more economically feasible. Even with the advent of redundant circuits and circuit boards, the system or bus must still be at least partially disabled to insert or remove a circuit board. Accordingly, it will be appreciated that it will be highly desirable to provide a circuit board for a computer system which can be inserted or removed without disabling the computer system.

With modern technological innovation, it is possible to detect the insertion or removal of a circuit board and, accordingly, disable a portion of the computer system, or to generate an error signal that alerts the system that a board is being inserted or removed. Even with modern technological innovations, there still exists a period of time in a computer system when the various system functions and the bus experience a lack of definition because of the insertion or removal of the circuit boards. Accordingly, it will be appreciated that it would be highly desirable to provide a circuit board which can be inserted or removed from an operating computer system without having to shut down the system and without introducing unmanageable error thereby increasing system efficiency.

Another object of the invention is to provide a circuit board which can be inserted in or removed from an on-line computer system without introducing unmanageable error.

Still another object of the invention is to provide a mechanically and electrically simple circuit board which can be inserted and removed from an operating computer system without the need to shut down the system.

Summary of the Invention

Briefly stated, in accordance with one aspect of the invention, the foregoing objects are achieved by providing a circuit board for on-line insertion in a computer system of the type having a plurality of clock lines including a clock line for the board, a bus and an INIT line carrying an INIT signal. The circuit board stops traffic on the bus during insertion of the board and decouples the clock line for the board from the other clock lines. The circuit board also provides fully distributed synchronization of the INIT signal.

The circuit board can be inserted in or removed from an operating computer system without the necessity of having to shut down the computer system or to stop the total bus function. The clock line is decoupled so that insertion or removal of the board does not generate errors. The circuit board uses straightforward circuitry to fully distribute synchronization of the INIT signal.

Brief Description of the Drawings

While the specification concludes with claims particularly pointing out and distinctly claiming the subject matter which is regarded as the invention, it is believed that the invention would be better understood from the following description of the preferred embodiment taken in conjunction with the accompanying drawings in which:

Fig. 1 is a schematic diagram of the backplane of a computer system and a circuit board illustrating a staggered arrangement of the connector terminals, the logic gate and the circuitry of the board; and

Fig. 2 is a schematic diagram of a circuit board incorporating a clock driver, a parameter controller and synchronization logic in accordance with the invention.

## Description of the Preferred Embodiment

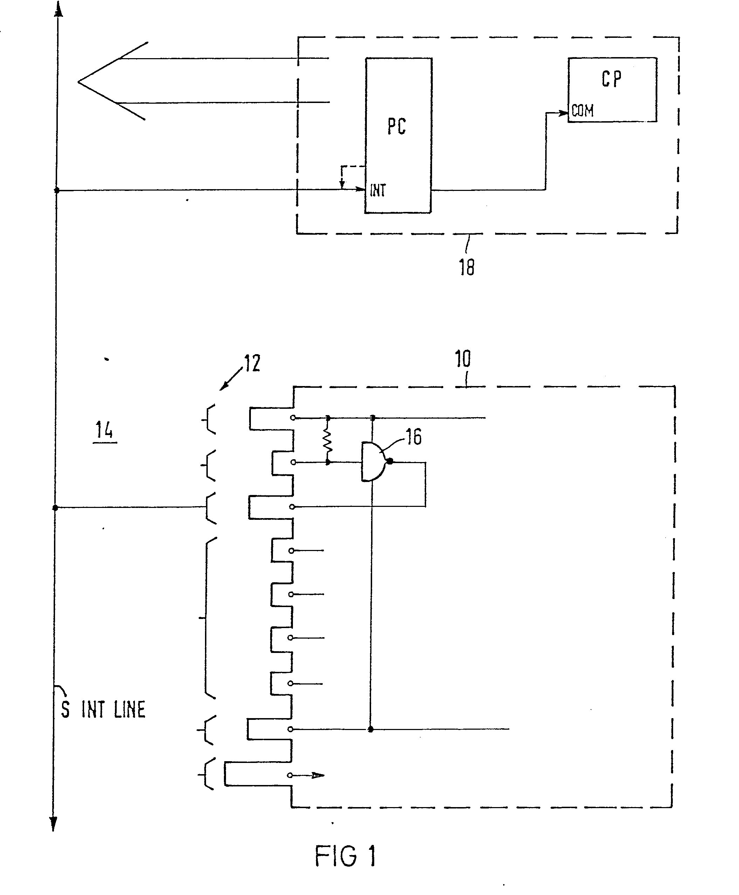

Referring to Fig. 1, there is shown a circuit board 10 for on-line insertion in a computer system 12 of the type having a back plane 14 with a plurality of terminals which are positioned on the board for making and breaking connection with the back plane terminals. The board terminals and backplane terminals are arranged to make and break contact in a specific sequence. The proper sequencing may be accomplished by staggering the terminals on the circuit board.

The circuit board 10 also includes a gate 16 whose output is connected to a micro-controller 18 which includes a parameter controller and a central controller which function to alert the computer that a board is being inserted or removed in accordance with the output of the gate 16.

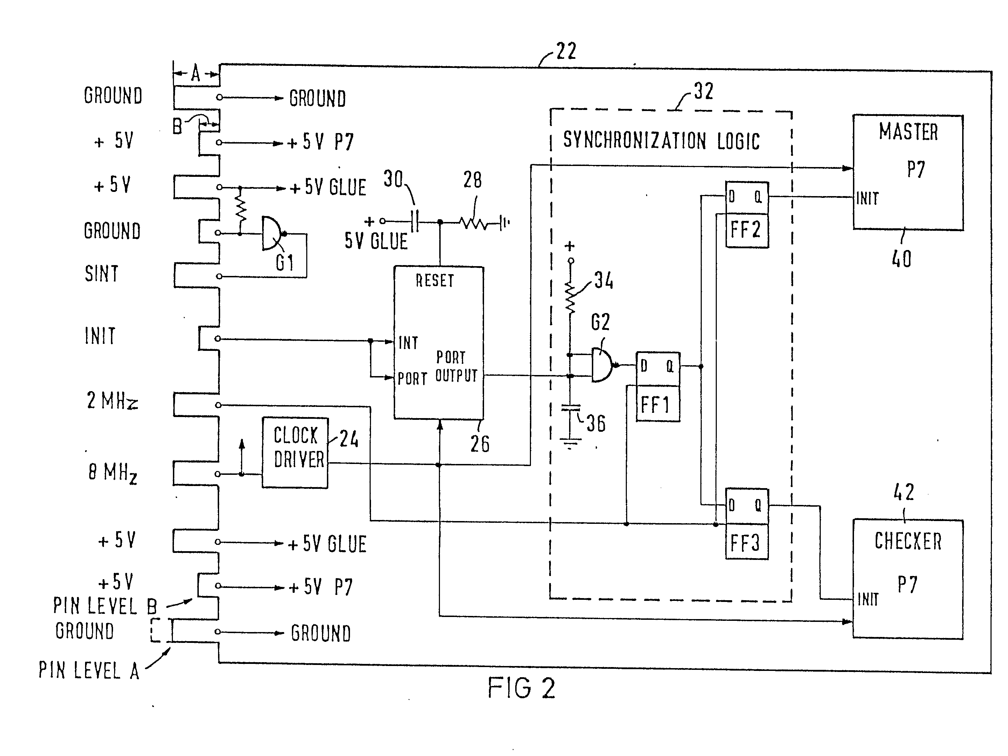

Referring to Fig. 2, a circuit board 22 has staggered connector terminals for on-line insertion in a computer system of the type having a plurality of clock lines including a clock line for the board, a bus and an INIT line carrying an INIT signal. The terminals on the board are in two or three levels. While two levels are sufficient from a functionality point of view, three levels are more satisfactory for the office or factory environment in which one might have to deal with static loads on the board. Generally, the pins which extend a distance A from the board contact the back plane before those pins which extend a distance A from the board are ground terminals, a +5 volt terminal, clock terminals and a system interrupt terminal. Terminals extending a distance B from the board include a +5 volt terminal, ground terminals and an INIT terminal.

Positioned on the board 22 is gate GI which halts traffic on the bus during insertion of the circuit board. The output of gate G1 is fed through the system interrupt terminal to the system interrupt line which freezes the bus during insertion of the board.

The clock line for the board carries a 8-megahertz clock signal which is received by a clock driver 24 positioned on the board. Ordinarily, insertion of the board causes glitches on the clock lines which would crash the system if other boards depend on the same clock signal. The clock distribution arrangement of the present invention uses separate clock lines and clock drivers for each board in the system. Thus, each clock line is decoupled from all the clock lines and glitches will not propagate through the system. The output of the clock driver 24 is connected to parameter controller 26.

The parameter controller 26 receives the INIT signal and generates a local INIT signal in response to receiving the system INIT signal. The initialization happens after a stable voltage on the board is established. This is the result of the +5V Glue with pin level A which is the first on the board before the +5V P7 with pin level B for the VLSI components is connected to the components. The parameter controller 26 has a reset terminal which is connected to the junction of resistor 28 and capacitor 30. The resistor 28 and capacitor 30 are connected in series with the other end of the capacitor being connected to a source of positive voltage and the other end of the resistor being grounded. This resistor capacitor combination controls the reset time and resetting of the parameter controller.

The output of the parameter controller 26 and the two-megahertz clock signal are received by a synchronization logic circuit 32. The synchronization logic circuit 32 includes gate G2 whose input is connected to the output of the parameter controller 26 and whose output is connected to the D input of flip-flop FF1. A resistor 34 and capacitor 36 are serially connected with the free end of the resistor connected to a source of positive voltage and the free end of the resistor connected to a source of positive voltage and the free end of the capacitor being grounded. The input of gate G2 is connected to the junction of resistor 34 and capacitor 36. This resistor-capacitor combination holds the gate output at a defined state until the parameter controller is reset. The Q output of flip-flop FF1 is connected to the D inputs of flip-flops FF2 and FF3. The two-megahertz clock signal is received by each of the flip-flops FF2, FF2 and FF3. The Q outputs of FF2 and FF3 are the local INIT signals and the Q output of FF2 for master components F40 and the Q output of FF3 becomes input for checker components 42. The synchronization of all P7 components is caused by a synchronization at one edge of the INIT signals.

Operation of the circuit board is fairly simple and straightforward. As the board is inserted into an operating computer system, the pins of various levels contact the backplane at different times. Initially, level A pins contact the backplane which generates a system interrupt signal alerting the computer system that the board is being inserted into the backplane. This system interrupt signal is received by the microcontroller 18 whose parameter controller then freezes the bus. Basically, this masks any distortions on the bus which might be the result of adding the board. This prevents the system from crashing as the board is inserted or removed. Freezing the bus does not help for signals which have a direct influence on the behavior of the hardware such as clock signals and the INIT signal.

The insertion of the board causes glitches on the clock lines. This will crash the system if other boards depend on the same clock signal. Fortunately, the clock distribution concept is based on separate clock lines and drivers 24 for each board in the system. By this construction, each clock line is decoupled from all other clock lines and glitches will not propagate through the system causing the system to malfunction or crash.

The state of the INIT input of the master and checker components is very important during operation and during the power-up cycle of the components. Since we assume glitches on the system INIT line during board insertion, we have to de-bounce this line. While filters are sometimes useful for de-bouncing, filters are not feasible at the INIT inputs of the components because the falling edge of the INIT signal synchronizes the components and this must occur within one 8-megahertz cycle (125 ns).

To make the system more reliable and tolerant, the INIT signals for the master and checker components on the board must be synchronized by separate hardware circuits. this configuration will allow error conditions on a single board as well as in the system without crashing the system.

The present invention provides a fully distributed synchronization of the INIT signal. In this invention, the system INIT signal is fed to the parameter controller of the board. On request (system INIT), all parameter controllers on the boards issue a local INIT signal which is connected to a two-level synchronization logic circuit. The first level guarantees the synchronization of both flip-flops in the second level. These flip-flops produce the local board INIT signals for the master and checker components. A two-megahertz phase clock (which is the divided clock frequency) clocks those flip-flops and determines the phase relationships of all components within the system.

The parameter controller requires approximately 10 milliseconds after power-up for resetting its ports. This requires a disabling function for the input of the INIT synchronization logic. The 10-millisecond reset time of the parameter controller cannot be masked by utilizing the staggered pins terminals. Thus, one input of gate G2 is connected to a resistor capacitor network which will hold the output of G2 at a defined state until the parameter controller is reset. The source for generating the local INIT signal on the board is the parameter controller. There are two events which stimulate the generation of the local INIT signal. Such a signal is generated every time the parameter controller is reset, such as during a power-up cycle, for example. The signal is generated when the parameter controller receives an INIT request signal. An INIT request will sustain the local INIT signal even when it was started by a power-up cycle.

From the foregoing, it is evident that the circuit board can be inserted into an operating computer system because the board freezes the bus automatically upon insertion of the board into the system until the board is fully inserted at which time the board removes the interrupt signal. By using the staggered terminals, the board is able to generate the system interrupt signal with a simple mechanical structure. Similarly, the board is easily removed from the operating system. Upon removal of the board from an operating system, the level A contacts separate causing the logic gate to go to its low state which generates the system interrupt function of the computer system. The staggered terminal has allowed the easy removal of the board from the backplane. Upon request, the parameter controller receives the system INIT signal and the 8-megahertz system clock signal from the clock driver and generates a signal which is received by the synchronization logic gate G2. Also received by the synchronization logic is a two-megahertz phase clock signal which synchronizes the flip-flops in the logic circuit. The logic flip-flops FF2 and FF3 output local board INIT signals.

It will now be understood that there has been presented a circuit board which can be inserted and removed from an operating computer system without the need to shut down the computer system. The circuit board can be inserted or removed from the computer system without introducing unmanageable error into the system. The circuit board is mechanically and electrically simple and can be inserted and removed without having to shut down the computer system. The circuit board provides for stopping traffic on the bus during insertion of the board and for decoupling clock lines for the board during insertion of the board. The circuit board also provides means for fully distributing synchronization of the INIT signal.

As will be evident from the foregoing description, certain aspects of the invention are not limited to the particular details of the examples illustrated, and it is therefore contemplated that other modifications or applications will occur to those skilled in the art. It is accordingly intended that the claims shall cover all such modifications and applications as do not depart from the true spirit and script of the invention.

## Claims

1. A circuit board for on-line insertion in a computer system of the type having a plurality of clock lines including a clock line for the board, a bus and an INIT line carrying an INIT signal, comprising:
means for stopping traffic on the bus during insertion of the board;
means for decoupling the clock line for the board from the other clock lines; and
means for providing fully distributed synchronization of the INIT signal.

2. A circuit board according to claim 1, including a parameter controller and wherein the means for decoupling the clock line includes a clock driver having its input connected to a terminal for receiving a clock signal from the clock line for the board and its output connected to the parameter controller.

3. A circuit board according to claim 2, wherein the parameter controller receives the INIT signal.

4. A circuit board according to claim 2, including a synchronization logic circuit having one input connected to the output of the parameter controller and having another input connected to a terminal for receiving a phase clock signal from one of the plurality of clock lines.

5. A circuit board according to claim 5, wherein the parameter controller generates a local INIT signal in response to receiving a system INIT signal.

6. A circuit board according to claim 1, wherein the means for decoupling the clock line includes a clock driver on the board having its input connected to a terminal for receiving a system clock signal from the clock line for the board and decoupling the system clock line from the plurality of clock lines.

7. A circuit board according to claim 1, wherein the means for providing fully distributed synchronization of the INIT signal includes:
a parameter controller receiving an INIT signal from the INIT line and a system clock signal from the clock line; and
a synchronization logic circuit receiving a local INIT signal from the parameter controller and receiving a phase clock signal from one of the plurality of clock lines and generating local board INIT signals.

8. A circuit board according to claim 9, wherein the synchronization logic circuit includes:
a logic gate receiving the local INIT signal from the parameter controller and producing an output in response to receiving the local INIT signal from the parameter controller;
a first flip-flop receiving the gate output at its input and being clocked by the phase clock signal;
a second flip-flop receiving the first flip-flop output and being clocked by the phase clock signal and producing one of the local board INIT signals; and
a third flip-flop receiving the first flip-flop output and being clocked by the phase clock signal and producing one of the local board INIT signals.

9. A circuit board according to claim 10, wherein the first flip-flop synchronizes the second and third flip-flops.

10. A circuit board according to claim 10, including a master component connected to the output of the second flip-flop and a checker component connected to the output of the third flip-flop.

11. A circuit board according to claim 10, including:
a resistor having one end connected to a source of positive voltage, and a capacitor having one end grounded and the other end connected to the free end of the resistor, said gate having its input connected to the junction of the resistor and capacitor, said resistor and capacitor holding the output of the gate at a defined state for a preselected time.

12. A circuit board according to claim 1, wherein the means for stopping bus traffic on the bus during insertion of the board includes staggered terminals.

13. A circuit board according to claim 1 wherein the computer system has a backplane with a plurality of terminals and the means for stopping traffic on the bus during insertion of the board includes:
a power terminal, a ground terminal and an output terminal each extending a distance A from the board;
at least one bus terminal extending a distance B from the board with distance A being greater than distance B;
a gate connected to the ground and power terminals and having its output connected to the output terminal and having its input connected to the ground and power terminals via a circuit which during board insertion applies the voltage potential of the ground terminal for a preselected time causing the gate output to go low thereby interrupting bus traffic and thereafter applies to the potential of the power terminal causing the gate output to go high thereby resuming bus traffic.

86 P 7408

FIG 1

FIG 2